# EUROPÄISCHE PATENTSCHRIFT

(11) **EP 3 527 933 B1**
(45) Veröffentlichungstag und Bekanntmachung des Hinweises auf die Patenterteilung: **07.09.2022**
(21) Anmeldenummer: 18156699.3
(22) Anmeldetag: 14.02.2018
(51) Int. Cl.: G01B 7/02, G01D 5/14, G01V 3/08, H03K 17/95

(54) **BESTIMMEN EINER ANNÄHERUNG**
DETERMINATION OF AN APPROXIMATION
DÉTERMINATION D'UNE APPROXIMATION

(43) Veröffentlichungstag der Anmeldung: 21.08.2019
(73) Patentinhaber: Loyalty Partner Solutions GmbH, 80339 München (DE)
(72) Erfinder: Kühnel, Stefan, 80636 München (DE); Mayer, Axel, 83026 Rosenheim (DE)
(74) Vertreter: Samson & Partner Patentanwälte mbB

(56) Entgegenhaltungen:
- EP-A1- 2 634 921
- US-A1- 2004 090 226
- US-B1- 8 683 707

## Beschreibung

### GEBIET DER ERFINDUNG

Die Erfindung betrifft das Bestimmen einer (räumlichen) Annäherung mittels eines Magnetfelds und eines Magnetfeldsensors.

### HINTERGRUND DER ERFINDUNG

Es ist bekannt, eine räumliche Annäherung beispielsweise mit einem Permanentmagneten und einem Reed-Kontakt zu realisieren. Unterhalb eines gewissen Abstands löst das Magnetfeld des Permanentmagneten einen Schaltvorgang im Reed-Kontakt aus, sodass sich eine Annäherung feststellen lässt.

Die US 8,683,707 B1 beschreibt einen ein- oder mehrachsigen Magnetfelddipolsender, um die Position und/oder Ausrichtung einer tragbaren Vorrichtung mit Magnetfeldsensorempfänger zu bestimmen.

### KURZFASSUNG DER ERFINDUNG

Die Erfindung ist durch die unabhängigen Ansprüche definiert.

Ein Aspekt der Erfindung betrifft ein System zum Bestimmen einer Annäherung. Das System umfasst einen Magnetfeldgenerator zum Erzeugen eines Magnetfelds, wobei das Magnetfeld mit einer Frequenz moduliert ist. Das System umfasst außerdem eine Messvorrichtung mit einem Magnetfeldsensor. Die Messvorrichtung ist eingerichtet, eine Messfolge von Magnetfeldstärken durch den Magnetfeldsensor zu erfassen und aus der Messfolge die Frequenz des Magnetfelds zu identifizieren. Die Annäherung basiert auf dem Identifizieren der Frequenz des Magnetfelds.

Ein weiterer Aspekt der Erfindung betrifft ein Verfahren zum Bestimmen einer Annäherung zwischen einem Magnetfeldgenerator und einer Messvorrichtung. Der Magnetfeldgenerator ist zum Erzeugen eines Magnetfelds eingerichtet, wobei das Magnetfeld des Magnetfeldgenerators mit einer Frequenz moduliert ist. Die Messvorrichtung ist mit einem Magnetfeldsensor ausgerüstet. Das Verfahren umfasst das Erfassen einer Messfolge von Magnetfeldstärken durch den Magnetfeldsensor, das Identifizieren der Frequenz(en) des Magnetfelds aus der Messfolge, und das Bestimmen der Annäherung basierend auf dem Identifizieren der Frequenz.

Ein weiterer Aspekt der Erfindung betrifft die Verwendung eines Mobiltelefons zur Durchführung eines solchen Verfahrens.

Weitere Aspekte und Merkmale der vorliegenden Erfindung ergeben sich aus den abhängigen Ansprüchen, den beigefügten Figuren und der nachfolgenden Beschreibung.

### KURZBESCHREIBUNG DER FIGUREN

Ausführungsbeispiele der Erfindung werden beispielhaft und unter Bezugnahme auf die beigefügten Figuren beschrieben, in der
Figur 1 schematisch ein Ausführungsbeispiel eines Systems zum Bestimmen einer Annäherung zeigt,
Figur 2 schematisch eine Messfolge bei einem System nach Figur 1 und ein Spektrum abgeleitet aus einer solchen Messfolge zeigt,
Figur 3 schematisch ein weiteres Ausführungsbeispiel eines Systems zum Bestimmen einer Annäherung zeigt,
Figur 4 schematisch ein Spektrum abgeleitet aus einer Messfolge bei einem System nach Figur 3 zeigt, und
Figur 5 schematisch ein Ausführungsbeispiel eines Verfahrens zum Bestimmen einer Annäherung zeigt.

### DETAILLIERTE BESCHREIBUNG

Die nachfolgende Beschreibung ist gleichermaßen auf das System und das Verfahren zum Bestimmen einer Annäherung zu verstehen. Das System umfasst einen Magnetfeldgenerator und eine Messvorrichtung. Der Magnetfeldgenerator erzeugt ein mit einer Frequenz moduliertes Magnetfeld. Die Messvorrichtung ist mit einem Magnetfeldsensor ausgerüstet, um eine Messfolge von Magnetfeldstärken zu erfassen. Die Messfolge repräsentiert mehrere, zeitlich nacheinander gemessene Samples der am jeweiligen Ort der Messvorrichtung vorliegenden Magnetfeldstärke. Des Weiteren ist die Messvorrichtung eingerichtet, auf Basis der Messfolge die Frequenz des von dem Magnetfeldgenerator erzeugten Magnetfelds zu identifizieren. Basierend auf der Identifikation der Frequenz bestimmt die Messvorrichtung die Annäherung zwischen Messvorrichtung und Magnetfeldgenerator.

Hierbei lässt sich eine Annäherung als ein Zustand auffassen, denn das Bestimmen einer Annäherung setzt voraus, dass sich Messvorrichtung und Magnetfeldgenerator innerhalb eines gewissen Abstandes zueinander befinden, sodass der Magnetfeldsensor das von dem Magnetfeldgenerator erzeugte Magnetfeld erfassen kann und die Messvorrichtung die Frequenz der Modulation des Magnetfelds identifizieren kann. Dieser gewisse Abstand ist beispielsweise durch die Stärke des erzeugten Magnetfeldes, die Empfindlichkeit des Magnetfeldsensors oder auch den Einfluss von magnetischen Störfeldern beeinflusst. Bei manchen Ausgestaltungen wird eine Annäherung in Reaktion darauf bestimmt, dass die Frequenz des Magnetfelds seitens der Messvorrichtung identifiziert wird. Vereinfacht ausgedrückt wird eine Annäherung dann festgestellt, wenn die Messvorrichtung das Magnetfeld anhand seiner (charakteristischen/bekannten) Frequenz erkennt. Bei manchen anderen Ausgestaltungen setzt das Bestimmen einer Annäherung weitere Voraussetzungen voraus, wie später exemplarisch erläutert wird. In solchen Ausgestaltungen ist das Identifizieren der Frequenz also lediglich eine notwendige Voraussetzung, um eine Annäherung feststellen.

Die Modulation des erzeugten Magnetfelds mit einer Frequenz ermöglicht es dem System, eine Annäherung zuverlässig zu bestimmen. Denn die Messvorrichtung kann das Magnetfeld des zum System gehörenden Magnetfeldgenerators anhand der verwendeten Frequenz identifizieren, sodass der Einfluss anderer (Stör-)Felder, die nicht diese Frequenz aufweisen, sowie auch eine Störung durch das Erdmagnetfeld, reduziert ist.

Die Zuverlässigkeit bei der Bestimmung einer Annäherung wird auch dadurch erhöht, dass bei der hier beschriebenen Vorgehensweise eine Messfolge von Magnetfeldstärken ermittelt wird und die Identifikation der Frequenz anhand dieser Messfolge durchgeführt wird. Denn die Frequenz des Magnetfelds lässt sich (bis zu einem gewissen Grad) zuverlässig anhand der Messfolge identifizieren, selbst wenn beispielsweise die absolute Feldstärke über die Dauer der Messfolge hinweg variiert, etwa falls die Messvorrichtung auf den Magnetfeldgenerator zu oder von diesem wegbewegt wird oder auch falls das von den Magnetfeldgenerator erzeugte Magnetfeld zeitlichen Schwankungen unterworfen ist.

Bei manchen Ausgestaltungen ist das Magnetfeld ein (zeitliches) Wechselfeld. Beispielsweise wird das Magnetfeld entsprechend der Frequenz der Modulation seitens des Magnetfeldgenerators fortlaufend umgepolt. Bei manchen Ausgestaltungen umfasst der Magnetfeldgenerator einen elektrischen Leiter oder eine Spule zur Erzeugung des Magnetfelds mittels eines elektrischen Stroms. Beispielsweise wird der elektrische Leiter oder die Spule mit einem Wechselstrom der genannten Frequenz betrieben und dadurch ein magnetisches Wechselfeld dieser Frequenz erzeugt.

Bei manchen Ausgestaltungen umfasst der Magnetfeldgenerator einen rotierbaren oder schwenkbaren Permanentmagneten. Beispielsweise sind ein oder mehrere Permanentmagneten auf einer Drehscheibe oder einem Drehreif angeordnet. Der Magnetfeldgenerator erzeugt durch Rotieren oder Schwenken ein mit der Rotationsfrequenz moduliertes Magnetfeld. Dies ermöglicht eine energiesparende Erzeugung des Magnetfelds, da beispielsweise keine hohen Spulenströme benötigt werden.

Bei manchen Ausgestaltungen umfasst der Magnetfeldgenerator eine Oberleitung zur Versorgung einer elektrischen Wechselstrombahn mit Bahnstrom. Hierbei erzeugt die Oberleitung aufgrund des Stromflusses des Betriebsstroms der Bahn ein Magnetfeld. Die Erfinder haben erkannt, dass manche Wechselstrombahnen charakteristische Wechselstromfrequenzen verwenden, beispielsweise 16.7 Hz in Deutschland, Österreich, Schweden, Norwegen oder auch der Schweiz. Dementsprechend ist das von einer Oberleitung erzeugte Magnetfeld mit dieser Frequenz 16.7 Hz moduliert und lässt sich hierdurch vom Erdmagnetfeld oder auch von Magnetfeldern unterscheiden, die beispielsweise von einem bei 50 Hz betriebenen Stromnetz herrühren. Ein derartiges System ist daher geeignet, eine elektrifizierte Bahnstrecke zu erkennen und eine Annäherung der Messvorrichtung an die Bahnstrecke zu bestimmen.

Die Messvorrichtung ist bei manchen Ausgestaltungen ein tragbares Gerät. Dadurch kann das System eine Annäherung des jeweiligen Trägers der Messvorrichtung an den Magnetfeldgenerator, beispielsweise eine elektrifizierte Bahnstrecke, bestimmen.

Die Erfinder haben erkannt, dass sich herkömmliche Mobiltelefone mit Kompass-Funktionalität, d. h. mit eingebautem Magnetfeldsensor, als Messvorrichtung eines erfindungsgemäßen Systems verwenden lassen. Bei manchen Ausgestaltungen ist die Messvorrichtung ein Mobiltelefon, insbesondere ein Smartphone, und/oder eine Uhr, beispielsweise in Gestalt einer Armbanduhr, insbesondere eine sogenannte Smartwatch, und/oder ein tragbares Gerät mit Unterhaltungselektronik-Funktionalität.

Bei manchen Ausgestaltungen umfasst der Magnetfeldsensor einen Hall-Sensor. Bei manchen Ausgestaltungen umfasst der Magnetfeldsensor einen magneto-resistiven Sensor, beispielsweise einen Giant Magneto-Resistive (GMR), Anisotropic Magneto-Resistive (AMR), Colossal Magneto-Resistive (CMR), Tunneling Magneto-Resistive (TMR) und/oder Extraordinary Magneto-Resistive (EMR) Sensor. Derartige Sensoren lassen sich kostengünstig in Halbleitertechnologie oder Dünnschichttechnologie herstellen, und zwar mit kleiner Baugröße. Auch sind sie für einen Batteriebetrieb geeignet und somit insbesondere für mobile Messvorrichtungen geeignet.

Bei manchen Ausgestaltungen hat die Messvorrichtung einen Ein-Achsen-Magnetfeldsensor. Bei manchen anderen Ausgestaltungen hat die Messvorrichtung einen Zwei-Achsen-Magnetfeldsensor oder einen Drei-Achsen-Magnetfeldsensor oder einen Magnetfeldsensor mit mehr als drei Achsen. Mehrachsige Magnetfeldsensoren ermöglichen zudem die Verwendung der Messvorrichtung als Kompass im Erdmagnetfeld. Ein- bzw. Mehrachsigkeit eines Magnetfeldsensors bedeutet, dass dieser genau eine bzw. mehrere Richtungskomponenten eines Magnetfelds erfassen kann, ohne hierfür räumlich neu ausgerichtet werden zu müssen. Ein Beispiel-Drei-Achsen-Magnetfeldsensor hat drei jeweils um 90° zueinander verdreht angeordnete einachsige Magnetfeldsensoren.

Bei manchen Ausgestaltungen erfasst die Messvorrichtung zusätzlich das Erdmagnetfeld durch den Magnetfeldsensor. Beispielsweise ermittelt die Messvorrichtung ihre Orientierung bezüglich des Magnetfelds im dreidimensionalen Raum. Bei manchen Ausgestaltungen wird eine Annäherungsrichtung im dreidimensionalen Raum ermittelt. Bei manchen Ausgestaltungen ermittelt die Messvorrichtung, in welcher Richtung (von ihr aus gesehen) im dreidimensionalen Raum sich der Magnetfeldgenerator befindet. So kann die Messvorrichtung beispielsweise einen Nutzer zum Standort des Magnetfeldgenerators leiten.

Bei manchen Ausgestaltungen wird die Messfolge von Magnetfeldstärken erfasst, wobei nur eine Achse eines mehrachsigen Magnetfeldsensors ausgelesen wird. Dadurch lässt sich beispielsweise der Stromverbrauch des Magnetfeldsensors reduzieren.

Bei manchen Ausgestaltungen wird auf eine Richtungsinformation bzw. die Unterscheidbarkeit verschiedener Richtungskomponenten des Magnetfelds bei der Erfassung der Messfolge verzichtet. Dadurch lässt sich beispielsweise Speicherplatz einsparen oder auch die Identifikation der Frequenz anhand der Messfolge in kürzerer Zeit durchführen. Beispielsweise werden als Messfolge jeweils kumulierte Werte erfasst, wobei ein kumulierter Wert Beiträge von mehreren Achsen des Magnetfeldsensors in sich vereint. Beispielsweise repräsentiert ein Messwert der Messfolge den Betrag der Summe über eine gemessene X-, Y-, und Z-Komponente eines Magnetfelds.

Bei manchen Ausgestaltungen umfasst das Identifizieren der Frequenz des Magnetfelds aus der Messfolge eine schnelle Fourier-Transformation (FFT), um ein Frequenzspektrum basierend auf der Messfolge zu bestimmen. Bei manchen Ausgestaltungen wird im (zugehörigen) Frequenzspektrum (der Messfolge) die Frequenz des modulierten Magnetfelds als ein Peak durch die Messvorrichtung festgestellt und dadurch die Frequenz identifiziert. Wie zuvor genannt, wird bei manchen Ausgestaltungen die Annäherung in Reaktion darauf, d.h. bereits dadurch bestimmt, dass die Frequenz des Magnetfelds seitens der Messvorrichtung identifiziert wird. Bei manchen anderen Ausgestaltungen werden für das Bestimmen der Annäherung eine oder mehrere weitere Voraussetzungen berücksichtigt.

Bei manchen Ausgestaltungen wird die magnetische Feldstärke in zeitlich regelmäßigen Abständen gemessen, sodass die Messfolge auf einer Zeitachse gesehen äquidistante Messwerte repräsentiert. Dadurch lässt sich die FFT unmittelbar auf die Messfolge anwenden, um ein Frequenzspektrum des gemessenen Magnetfelds zu bestimmen.

Bei manchen anderen Ausgestaltungen wird die Magnetfeldstärke in zeitlich unregelmäßigen Abständen gemessen. Hier lassen sich beispielsweise mittels linearer Interpolation äquidistante Stützstellen für die FFT bereitstellen. Bei manchen Ausgestaltungen werden Messwerte der Magnetfeldstärke mit einem Zeitstempel versehen, sodass sie sich auf einer Zeitachse korrekt einordnen lassen. Auch lassen sich basierend auf den Zeitstempeln äquidistante Stützstellen für die FFT bestimmen. Dies ermöglicht beispielsweise die Verwendung eines Nicht-Echtzeit-Betriebssystems der Messvorrichtung, bei dem nicht sichergestellt ist, dass die Messung der Magnetfeldstärke durch den Magnetfeldsensor zu exakt definierten Zeitpunkten erfolgt. Dies ist vorteilhaft bei Ausgestaltungen mit einem herkömmlichen Mobiltelefon als Messvorrichtung, welches Kompassdaten, d.h. Messwerte eines Magnetfeldsensors, in unregelmäßigen zeitlichen Abständen liefert.

Bei manchen Ausgestaltungen wird auch die Magnetfeldstärke in die Bestimmung der Ortsinformationen mit einbezogen, um die Nähe zu einem Magnetfeldgenerator zu bestimmen oder auch von anderen zufällig ebenfalls vorhandenen Magnetfeldgeneratoren derselben Frequenz oder anderen Störfeldern derselben Frequenz unterscheiden zu können.

Bei manchen Ausgestaltungen hat die Messvorrichtung eine Einrichtung zum Bestimmen von Ortsinformationen (betreffend einen momentanen Aufenthaltsort der Messvorrichtung). Beispielsweise ist die Messvorrichtung mit einem GPS-Empfänger ausgerüstet, der Geokoordinaten als Ortsinformation liefert. Zusätzlich oder alternativ ermittelt die Messvorrichtung bei manchen Ausgestaltungen Ortsinformationen mithilfe eines Mobilfunknetzes, eines WLAN-Knotens oder eines Bluetooth-Beacons. Bei manchen Ausgestaltungen wird eine Ortsinformation beim Bestimmen der Annäherung berücksichtigt.

Die Annäherung wird in Reaktion darauf bestimmt, dass (zunächst) für eine erste Ortsinformation (d.h. erste Position der Messvorrichtung) die Frequenz des Magnetfelds identifiziert wird und (anschließend) für eine zweite Ortsinformation (d.h. zweite Position der Messvorrichtung) die Frequenz des Magnetfelds ein weiteres Mal identifiziert wird, wobei die erste Ortsinformation und die zweite Ortsinformation zueinander beabstandete Orte bezeichnen. Dies gestattet, dass bei manchen Ausgestaltungen die Messvorrichtung bestimmt, ob sie sich (aller Wahrscheinlichkeit nach) in einem fahrenden Zug befindet. Denn die Frequenz des Magnetfelds einer Oberleitung einer elektrischen Bahn kann die Messvorrichtung sowohl auf einem Bahnsteig (außerhalb eines Zugs) identifizieren, als auch wenn sie innerhalb eines Zugs lokalisiert ist. Unter Berücksichtigung des zusätzlichen Kriteriums, dass die Frequenz des Magnetfelds nacheinander, also wiederholt, an zumindest zwei, beispielsweise um mindestens 100 m, 500 m oder 1 km, zueinander beabstandeten Orten identifiziert wurde, lässt sich als Annäherung bestimmen, dass sich die Messvorrichtung innerhalb eines fahrenden Zugs befindet (und aller Wahrscheinlichkeit nach nicht auf einem Bahnsteig).

Bei manchen Ausgestaltungen umfasst das Bestimmen der Annäherung - zusätzlich zu dem Identifizieren der Frequenz des Magnetfelds - auch noch das Berücksichtigen von Informationen anderer Sensoren, wie beispielsweise eines GPS-Sensors, eines Geschwindigkeitssensors, eines Beschleunigungssensors, eines Luftdrucksensors, eines Mikrofons, oder eines Helligkeitssensors. Dadurch lässt sich die Zuverlässigkeit beim Bestimmen einer Annäherung erhöhen, indem durch einen oder mehrere solcher Sensoren zusätzliche Kriterien bestimmt und berücksichtigt werden, welche einen Ort des bzw. die Nähe zu einem Magnetfeldgenerator des Systems charakterisieren.

Die Messvorrichtung ist bei manchen Ausgestaltungen mit einer Anzeige für eine grafische Benutzerschnittstelle (GUI) ausgerüstet, beispielsweise einem Display eines Smartphones. In Reaktion auf das Identifizieren der Frequenz des Magnetfelds zeigt bei manchen Ausgestaltungen die Messvorrichtung ein grafisches Element, beispielsweise ein graphisches Symbol, einen Hinweistext oder ein Dialogfeld der GUI an. Dadurch lässt sich beispielsweise der Benutzer der Messvorrichtung informieren, dass eine Annäherung stattfand. Beispielsweise kann bei einem Smartphone als Messvorrichtung dem Benutzer beim Betreten eines Bahnsteigs ein Hinweis auf dem Display des Smartphones eingeblendet werden, der an den Erwerb eines Tickets erinnert. Wie zuvor bereits genannt, kann die Messvorrichtung weitere Kriterien bei der Bestimmung einer Annäherung zusätzlich heranziehen. Beispielsweise lässt sich die Zuverlässigkeit bei der Bestimmung einer Annäherung (z.B. an einen Bahnsteig) dadurch erhöhen, dass Geo-Koordinaten berücksichtigt werden, die beispielsweise mit einem GPS-Empfänger erfasst werden. Zusätzlich oder alternativ lässt sich auch eine Anwesenheit eines Bluetooth-Beacon, das beispielsweise am Bahnsteig und/oder einer Werbetafel platziert ist, als weiteres Kriterium berücksichtigen.

Bei manchen Ausgestaltungen wird in Reaktion auf das Bestimmen einer Annäherung (selbstständig) eine Applikation gestartet. Beispielsweise lässt sich ein Web-Browser mit einer URL starten, unter der weitere Information abgerufen werden, die insbesondere im Kontext zu dem Ort stehen, an dem sich der Magnetfeldgenerator befindet, an den die Annäherung stattfand. Bei manchen Ausgestaltungen wird bei einem Smartphone als Messvorrichtung ein Applikation zum Erwerb eines Bahntickets (automatisch) gestartet, wenn das Smartphone eine Annäherung an eine Oberleitung bestimmt, da dies aller Wahrscheinlichkeit nach damit einhergeht, dass der Benutzer des Smartphones einen Bahnsteig betreten hat.

Bei manchen Ausgestaltungen ist das Starten einer Applikation von weiteren Kriterien abhängig, die insbesondere basierend auf einem weiteren Sensor der Messvorrichtung bestimmt werden. Beispielsweise kann das Starten einer Applikation zum Erwerb eines Tickets zusätzlich von einer Ortsinformation und/oder einer Geschwindigkeitsinformation abhängig durchgeführt werden, etwa um zu unterscheiden, ob ein Benutzer einen Bahnsteig betritt oder sich dem Magnetfeld der Oberleitung gewissermaßen unbeabsichtigt, etwa beim Passieren eines Bahnübergangs näherte.

In manchen Ausgestaltungen, insbesondere bei Ausgestaltungen mit einem Smartphone als Messvorrichtung, ist eine Annäherungs-Applikation realisiert, die anderen Applikationen eine Schnittstelle bereitstellt, um über eine Annäherung zu informieren. Dadurch können beliebige Applikationen Kenntnis darüber gelangen, ob eine Annäherung der Messvorrichtung bzw. des Smartphones an einem Magnetfeldgenerator des Systems erfolgte (oder auch nicht erfolgte).

In manchen Ausgestaltungen, insbesondere mit einem Smartphone als Messvorrichtung, lässt sich der Erwerb eines Tickets für eine Zugverbindung mittels einer Applikation blockieren, sobald als Annäherung bestimmt wurde, dass sich die Messvorrichtung in einem fahrenden Zug befindet. Dadurch lässt sich beispielsweise ein missbräuchliches Online-Nachlösen von Tickets unterbinden, falls durch Beförderungsbedingungen das Lösen von Tickets vor Fahrtbeginn gefordert ist.

Wie zuvor erläutert kann bei manchen Ausgestaltungen das System bereits vorhandene Magnetfeldgeneratoren, wie beispielsweise eine Oberleitung einer Bahnstrecke, umfassen. Bei manchen Ausgestaltungen ist ein Magnetfeldgenerator in Gestalt eines magnetischen Beacons vorgesehen, das insbesondere von dem Betreiber des Systems installiert und/oder betreibbar ist. Ein derartiges magnetisches Beacon umfasst beispielsweise eine Antenne, eine Spule oder einen Permanentmagneten zum Erzeugen eines magnetischen oder auch elektromagnetischen Feldes mit einer bestimmten Frequenz. Derartige Beacon lassen sich beispielsweise an Eingängen oder Ausgängen oder an anderen Positionen innerhalb von Fahrzeugen, Gebäuden oder Geländen anordnen, beispielsweise an bestimmten Stellen eines Verkaufsraums, etwa in der Nähe von oder in einem Verkaufsautomaten, oder etwa in einem Speisewagen eines Zuges. Damit ermöglicht ein zuvor beschriebenes System das Bestimmen einer Annäherung der Messvorrichtung an ein solches Beacon. Die vorausgehenden und nachfolgenden Erläuterungen betreffend einen Magnetfeldgenerator sind gleichermaßen als derartige Beacons betreffend zu verstehen.

Bei manchen Ausgestaltungen umfasst das System mehrere Magnetfeldgeneratoren. Bei manchen dieser Ausgestaltungen umfasst das System zumindest einen (ersten) Magnetfeldgenerator zum Erzeugen eines Magnetfelds mit einer ersten Frequenz und zumindest einen (zweiten) Magnetfeldgenerator zum Erzeugen eines Magnetfelds mit einer zweiten Frequenz.

Bei manchen Ausgestaltungen ist die Messvorrichtung eingerichtet, eine erste Frequenz und eine zweite Frequenz zu identifizieren oder auch mehr als zwei Frequenzen zu identifizieren, und zwar beispielsweise gleichzeitig. Dadurch kann die Messvorrichtung bei der Bestimmung einer Annäherung zwei oder mehr Magnetfeldgeneratoren unterscheiden. Bei manchen Ausgestaltungen erzeugt jeder individuelle Magnetfeldgenerator des Systems ein Magnetfeld mit einer individuellen Frequenz. Dadurch lassen sich die Magnetfeldgeneratoren des Systems sämtlich unterscheiden. Bei manchen Ausgestaltungen ist die Messvorrichtung eingerichtet, eine Annäherung an einen ersten Magnetfeldgenerator verschieden von einer Annäherung an einen zweiten Magnetfeldgenerator zu bestimmen. Derart verschieden bestimmte Annäherungen umfassen beispielsweise eine Unterscheidungsinformation, beispielsweise die identifizierte Frequenz und/oder eine ID desjenigen Magnetfeldgenerators, an den die jeweilige Annäherung festgestellt wurde.

Bei manchen Ausgestaltungen wird innerhalb des Systems eine geringere Anzahl von Frequenzen bei der Modulation von Magnetfeldern verwendet als eine Anzahl von Magnetfeldgeneratoren des Systems. Beispielsweise sind zumindest zwei Magnetfeldgeneratoren, die jeweils ein Magnetfeld mit derselben Frequenz modulieren, und zumindest eine dritter Magnetfeldgenerator, der ein Magnetfeld mit einer weiteren Frequenz moduliert, vorgesehen. Dadurch lassen sich innerhalb des Systems Klassen von Magnetfeldgeneratoren unterscheiden. Beispielsweise können durch eine erste Frequenz Oberleitungen von elektrifizierten Bahnstrecken als eine erste Klasse von Magnetfeldgeneratoren charakterisiert sein und durch eine zweite Frequenz als eine weitere Klasse jeweilige Standorte von Ticketautomaten, die mit Magnetfeldgeneratoren zur Erzeugung eines Magnetfelds mit der zweiten Frequenz ausgerüstet sind.

Bei manchen Ausgestaltungen ist die Messvorrichtung eingerichtet, eine Annäherung an einen ersten Magnetfeldgenerator von einer Annäherung an einen zweiten Magnetfeldgenerator zu unterscheiden, falls diese Magnetfelder mit derselben Frequenz modulieren, indem die Messvorrichtung ein (weiteres) Unterscheidungskriterium anwendet. Ein solches Unterscheidungskriterium ist beispielsweise eine Ortsinformation, diesbezüglich sich der erste und der zweite Magnetfeldgenerator unterscheiden. Beispielsweise ist die Messvorrichtung mit einem Speicher mit Ortsinformationen über Magnetfeldgeneratoren, etwa in Gestalt einer elektronischen Karte, ausgerüstet. Beispielsweise ist die Messvorrichtung mit einem GPS-Sensor ausgerüstet und kann ihre momentane Position bestimmen. Durch einen Vergleich der momentanen Position mit gespeicherten Ortsinformationen über Magnetfeldgeneratoren kann in manchen Ausgestaltungen die Messvorrichtung Magnetfeldgeneratoren unterscheiden, selbst wenn diese dieselbe Frequenz zum Modulieren ihres Magnetfelds verwenden.

Bei manchen Ausgestaltungen kann die Messvorrichtung zwei oder mehrere Frequenzen von Magnetfeldern gleichzeitig identifizieren. Damit kann die Messvorrichtung eine gleichzeitige Annäherung an zwei bzw. mehrere Magnetfeldgeneratoren bestimmen. Bei manchen Ausgestaltungen bestimmt die Messvorrichtung anhand der Messfolge basierend auf Signalstärken von zwei oder mehreren Frequenzen der gemessenen Magnetfeldstärke relative Abstände zu zwei oder mehreren Magnetfeldgeneratoren, beispielsweise durch Triangulation.

Um beispielsweise einem Magnetfeldgenerator eine Identifikationsinformation, ID, zuzuordnen, ist bei manchen Ausgestaltungen der Magnetfeldgenerator eingerichtet, ein Magnetfeld zu erzeugen, dass mit einer von n vorgesehenen (verschiedenen) Frequenzen moduliert ist. Dadurch lassen sich innerhalb des Systems n Magnetfeldgeneratoren (anhand ihrer Modulationsfrequenz) voneinander unterscheiden. Bei manchen dieser Ausgestaltungen unterscheiden sich benachbarte Frequenzen der n vorgesehenen Frequenzen beispielsweise um 0.1 Hz.

Bei manchen Ausgestaltungen ist der Magnetfeldgenerator eingerichtet, ein Magnetfeld zu erzeugen, dass gleichzeitig mit zwei oder mehreren Frequenzen moduliert ist, etwa um dem Magnetfeldgenerator eine Identifikationsinformation, ID, zuzuordnen. Sind beispielsweise bei einem System n (verschiedene) Frequenzen vorgesehen, so lassen sich bis zu 2ⁿ-1 Magnetfeldgeneratoren anhand der von ihnen erzeugten Magnetfelder identifizieren, falls die Magnetfeldgeneratoren ihre Magnetfelder mit einer Kombination von bis zu n Stück dieser Frequenzen modulieren. Hierbei lässt sich die Abwesenheit bzw. das Vorhandensein einer der n Frequenzen (bei der Modulation eines jeweiligen Magnetfelds) als ein binärer Wert einer im Binärsystem n-stelligen ID (des zugehörigen Magnetfeldgenerators) interpretieren.

Bei manchen Ausgestaltungen ist der Magnetfeldgenerator eingerichtet, ein Magnetfeld zu erzeugen, dessen Amplitude nach einem binär codierten Muster variiert wird. Die Messvorrichtung kann das binär codierte Muster bei der Amplitudenmodulation mittels des Magnetfeldsensors auslesen. So lässt sich beispielsweise dem Magnetfeldgenerator eine dem binär codierten Muster entsprechende ID zuordnen oder auch eine binär codierte Information übertragen.

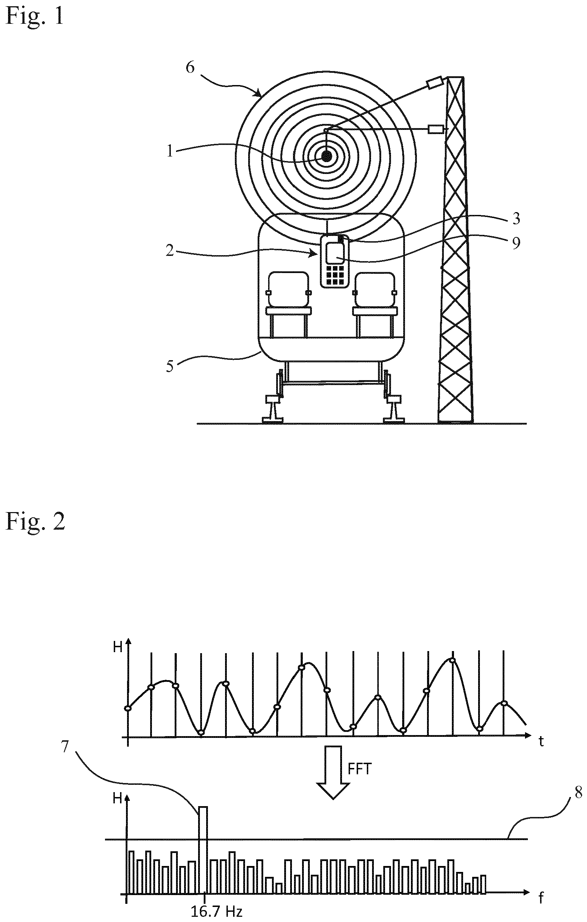

Fig. 1 zeigt schematisch ein Beispiel eines Systems zum Bestimmen einer Annäherung zwischen einem Magnetfeldgenerator und einer Messvorrichtung mit einem Magnetfeldsensor 3. Bei diesem Beispiel ist der Magnetfeldgenerator in Gestalt einer Oberleitung 1 für einen elektrischen Zug 5 realisiert, und die Messvorrichtung ist in Gestalt eines Mobiltelefons 2 mit einer Anzeige 9 realisiert. Ein in der Oberleitung 1 fließender Wechselstrom hat eine Frequenz von beispielsweise 16.7 Hz. Durch diesen Stromfluss erzeugt die Oberleitung 1 ein Magnetfeld 6, das mit dieser Frequenz 16.7 Hz moduliert ist. Das System umfasst eine Mehrzahl Magnetfeldgeneratoren, nämlich sämtliche Oberleitungen des elektrifizierten Schienennetzes. Zudem umfasst das System eine Mehrzahl Messvorrichtungen, nämlich sämtliche Mobiltelefone 2, die mit einem Magnetfeldsensor sowie einer entsprechenden Applikation ausgerüstet sind, um die nachfolgend beschriebene Funktionalität bereitzustellen. Das Mobiltelefon 2 kann einen Hinweis in einer graphischen Benutzerschnittstelle (GUI) auf der Anzeige 9 einblenden, wenn eine Annäherung bestimmt wurde. Beispielsweise kann das Mobiltelefon 2 eine Applikation in Reaktion auf das Bestimmen einer Annäherung automatisch starten und auf der Anzeige darstellen, die dem Benutzer weitere Interaktionsmöglichkeiten bietet. Exemplarisch bezieht sich die nachfolgende Beschreibung auf einen Magnetfeldgenerator und eine Messvorrichtung, ist jedoch gleichermaßen auf die übrigen Magnetfeldgeneratoren und Messvorrichtungen des Systems zu verstehen.

Das System erlaubt festzustellen, ob sich das Mobiltelefon 2 in einem fahrenden Zug 5 befindet. Hierzu erfasst das Mobiltelefon 2 mit seinem eingebauten Magnetfeldsensor 3 Messwerte der Magnetfeldstärke, die das Mobiltelefon 2 umgibt. Das Mobiltelefon 2 erzeugt eine Messfolge die eine Mehrzahl solcher Messwerte in chronologischer Abfolge umfasst. Unter Verwendung einer schnellen Fourier-Transformation erzeugt das Mobiltelefon 2 aus der Messfolge ein zugehöriges Frequenzspektrum. Dies ist schematisch in Fig. 2 illustriert, wobei in der oberen Hälfte die Messfolge und in der unteren Hälfte das (Frequenz-) Spektrum dargestellt ist.

Hat sich das Mobiltelefon 2 der Oberleitung 1 angenähert, sodass der Magnetfeldsensor 3 das Magnetfeld 6 wahrnimmt, so findet sich, wie in Fig. 2 gezeigt, im Spektrum ein Peak 7 bei 16.7 Hz, der der Modulationsfrequenz des Magnetfelds 6 entspricht. Dieser Peak 7 lässt sich beispielsweise dadurch identifizieren, dass seine Peakhöhe einen gewissen Schwellwert 8 überschreitet. Damit "weiß" das Mobiltelefon 2, dass es sich in der Nähe der Oberleitung 1, insbesondere in einem Waggon des Zuges 5 befindet. Das Mobiltelefon 2 bestimmt daher die Annäherung an den Magnetfeldgenerator, bei diesem Beispiel die Oberleitung 1, basierend darauf, dass aus der Messfolge (beispielsweise mithilfe des daraus abgeleiteten Frequenzspektrums) die Frequenz des Magnetfelds 6 identifiziert wird.

Grundsätzlich können in dem Spektrum weitere Peaks auftreten, beispielsweise bedingt durch Störfelder oder Oberwellen oder auch durch Artefakte bei der schnellen Fourier-Transformation. Da das Mobiltelefon 2 bei manchen Beispielen die im System verwendeten Frequenzen der Magnetfeldgeneratoren kennt, kann es gezielt nach den "richtigen" Peaks, sprich den von den Magnetfeldgeneratoren verwendeten Frequenzen, suchen und andere Peaks durch Störfelder usw. ignorieren.

Bei manchen Beispielen kann das Mobiltelefon 2 zudem bestimmen, ob es sich (aller Wahrscheinlichkeit nach) innerhalb des Zugs 5 befindet oder ob lediglich eine Annäherung an die Oberleitung 1, z.B. durch Betreten eines Bahnsteigs, stattfand. Hierzu führt das Mobiltelefon 2 beispielsweise in gewissem zeitlichem Abstand nacheinander zwei Ortsbestimmungen durch, beispielsweise mittels eines GPS-Empfängers. Wenn hierbei festgestellt wird, dass das Mobiltelefon 2 eine größere Strecke zurückgelegt hat, als dies für einen Fußgänger charakteristisch ist, und jeweils die Frequenz der Oberleitung 1 identifiziert wurde, bestimmt das Mobiltelefon 2 eine Annäherung an das Innere eines fahrenden Zuges 5. Zusätzlich oder alternativ bestimmt das Mobiltelefon 2 seine aktuelle Geschwindigkeit, etwa mittels eines GPS-Empfängers. Den Umstand, dass die aktuelle Geschwindigkeit untypisch für einen Fußgänger ist, kann das Mobiltelefon 2 als ein (zusätzliches oder alternatives) Kriterium heranziehen, um festzustellen, dass sich das Mobiltelefon innerhalb eines fahrenden Zuges 5 befindet.

Bei manchen Beispielen ist, etwa aufgrund des Betriebssystems des Mobiltelefons 2, der zeitliche Abstand zwischen den Messwerten der Magnetfeldstärke unregelmäßig. Beispielsweise verwendet das Mobiltelefon 2 eine lineare Interpolation, um die Messfolge mit zeitlich regelmäßigen Messwerten zu erzeugen. Bei derartigen Beispielen kann die Messfolge also gewissermaßen echte Messwerte und/oder interpolierte Messwerte enthalten.

Bei manchen Beispielen ist das System für Frequenzen bis maximal 40 Hz, 50 Hz oder 60 Hz der Modulation des Magnetfelds 6 vorgesehen. Damit lässt sich eine jeweils verwendete Frequenz des Magnetfelds zuverlässig identifizieren, wenn der Magnetfeldsensoren im Wesentlichen maximal 100 Messungen pro Sekunde erlaubt. Manche Beispiel-Systeme nutzen eine oder mehrere Frequenzen zwischen 10 Hz und 15 Hz oder auch Frequenzen zwischen 18 Hz und 48 Hz bei der Modulation der Magnetfelder. Damit lassen sich Annäherungen an Magnetfeldgeneratoren des Systems zuverlässiger erkennen und von Störfeldern des Bahnstrom oder des öffentlichen Stromnetzes unterscheiden.

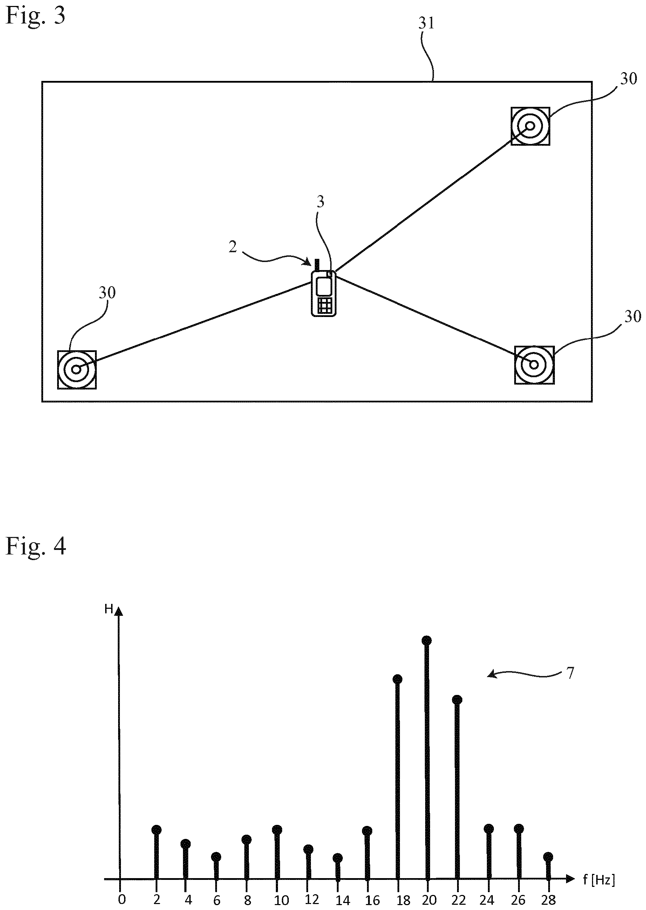

Fig. 3 illustriert schematisch ein System mit mehreren Magnetfeldgeneratoren, die in Gestalt von magnetischen Beacons 30 realisiert sind. Als Messvorrichtung sind bei diesem System ein oder mehrere Mobiltelefone 2 vorgesehen, die jeweils mit einem Magnetfeldsensor ausgerüstet sind. Dieses System erlaubt unter Verwendung von jeweils drei (oder mehr) magnetischen Beacons 30 beispielsweise eine Navigation in Innenräumen unter Nutzung eines Triangulationsverfahrens. Hierzu sind beispielsweise in einem Raum 31 drei Beacons 30 räumlich beabstandet platziert, wobei jedes Beacon 30 ein mit einer individuellen Frequenz moduliertes Magnetfeld erzeugt. Beispielsweise moduliert ein erstes Beacon 30 mit 18 Hz, ein zweites Beacon mit 20 Hz und ein drittes Beacon mit 22 Hz.

Wie zuvor erläutert, erfasst das Mobiltelefon 2 eine Messfolge von Messwerten der Magnetfeldstärke und erzeugt hieraus ein Spektrum, z.B. mit Hilfe einer schnellen Fourier-Transformation. Wenn sich das Mobiltelefon 2 in der Nähe der drei Beacons 30 befindet, kann das Mobiltelefon gewissermaßen alle drei Beacons 30 "sehen", d.h. der Magnetfeldsensor erfasst eine Überlagerung sämtlicher von den drei Beacons 30 erzeugten Magnetfelder.

Dadurch weist, wie in Fig. 4 veranschaulicht, das von dem Mobiltelefon 2 erzeugte Spektrum drei Peaks 7 auf, und zwar entsprechend den Modulationsfrequenzen der Magnetfelder jeweils ein Peak 7 bei 18 Hz, 20 Hz und 22 Hz. Die vom Mobiltelefon 2 gemessene Magnetfeldstärke korreliert mit dem Abstand des Mobiltelefons 2 von den drei magnetischen Beacons 30. Unter Kenntnis der Lage dieser Beacons 30 im Raum 31 kann das Mobiltelefon 2 eine Triangulation durchführen und seinen aktuellen Aufenthaltsort innerhalb des Raums 31 ermitteln.

Bei manchen weiteren Beispielen ist das System ausgerüstet zu erkennen, ob sich das Mobiltelefon 2 in der Nähe eines bestimmten von mehreren magnetischen Beacons befindet. Dazu ist das System in der Lage, magnetische Beacons eindeutig zu identifizieren.

Bei manchen Beispielen verwenden die Beacons jeweils eine individuelle Frequenz zur Modulation des Magnetfeldes. Das Identifizieren eines Beacons erfolgt anhand der im System bekannten Frequenz des vom jeweiligen Beacon erzeugten magnetischen Feldes. Beispielsweise unterscheiden sich die verwendeten Frequenzen der Beacons um jeweils 1 Hz oder 0.1 Hz.

Bei manchen Beispielen sind magnetische Beacons des Systems eingerichtet, das von ihnen erzeugte Magnetfeld mit bis zu n verschiedenen Frequenzen überlagert zu modulieren, beispielsweise mit Frequenzen von 10.0 Hz, 10.1 Hz, 10.2 Hz und 10.3 Hz. Um derartige Beacons eindeutig zu identifizieren, insbesondere einem Beacon eine eindeutige ID zuzuordnen, verwendet jedes der Beacons eine eindeutige Kombinationen der n vorgesehenen Modulationsfrequenzen. Damit lassen sich 2ⁿ-1 verschiedene Beacons unterscheiden. Dies sei exemplarisch für vier Modulationsfrequenzen tabellarisch veranschaulicht:

| Beacon ID | 10.0 Hz | 10.1 Hz | 10.2 Hz | 10.3 Hz |
|---|---|---|---|---|
| 0 | 1 | 0 | 0 | 0 |
| 1 | 1 | 0 | 0 | 1 |
| 2 | 1 | 0 | 1 | 0 |
| 3 | 1 | 0 | 1 | 1 |
| 4 | 1 | 1 | 0 | 0 |
| 5 | 1 | 1 | 0 | 1 |
| 6 | 1 | 1 | 1 | 0 |
| 7 | 1 | 1 | 1 | 1 |
| 8 | 0 | 0 | 0 | 1 |
| 9 | 0 | 0 | 1 | 0 |
| 10 | 0 | 0 | 1 | 1 |
| 11 | 0 | 1 | 0 | 0 |
| 12 | 0 | 1 | 0 | 1 |
| 13 | 0 | 1 | 1 | 0 |
| 14 | 0 | 1 | 1 | 1 |

Bei diesem Beispiel moduliert das Beacon mit der ID=0 lediglich mit der Frequenz 10.0 Hz. Das Beacon mit der ID=1 moduliert das Magnetfeld mit zwei Frequenzen überlagert, nämlich 10.0 Hz und 10.3 Hz. Das Mobiltelefon 2 ist somit in der Lage, sämtliche 15 Beacons mit ID=0..14 durch ihre individuelle Kombination der insgesamt vier verwendeten Modulationsfrequenzen eindeutig zu identifizieren.

Bei manchen Beispielen modulieren ein oder mehrere Beacons das jeweils erzeugte Magnetfeld 6 zusätzlich zu der zuvor beschriebenen Frequenz auch noch hinsichtlich der Amplitude. Durch diese Amplitudenmodulation kann ein derartiges Beacon Information aussenden, welche das Mobiltelefon 2 auswerten kann. Beispielsweise ändert sich aufgrund der Amplitudenmodulation die Höhe des Peaks 7 in zeitlicher Abfolge, wenn das Mobiltelefon 2 nacheinander mehrere Messfolgen erzeugt und zugehörige Spektren bestimmt. Bei manchen Beispielen wird mit der Amplitudenmodulation eine binär codierte, insbesondere für das jeweilige Beacon eindeutige, ID-Nummer ausgesendet.

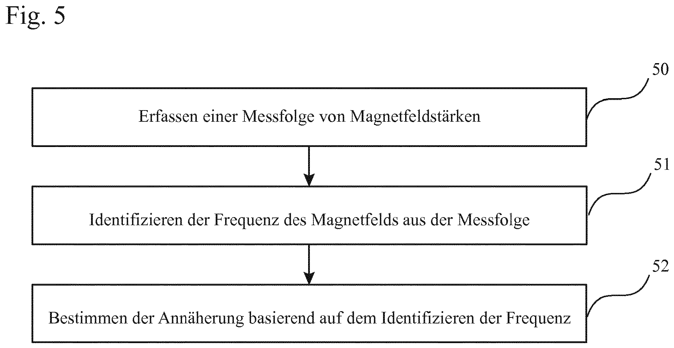

Fig. 5 zeigt schematisch ein Beispiel eines Verfahrens zur Bestimmung einer Annäherung zwischen einem Magnetfeldgenerator 1 zum Erzeugen eines Magnetfelds 6 und einer Messvorrichtung 2 mit einem Magnetfeldsensor 3. Das Verfahren umfasst das Erfassen 50 einer Messfolge von Magnetfeldstärken durch den Magnetfeldsensor 3, das Identifizieren 51 der Frequenz des Magnetfelds aus der Messfolge, und das Bestimmen 52 der Annäherung basierend auf dem Identifizieren der Frequenz.

## Patentansprüche

1. System zum Bestimmen einer Annäherung, umfassend:
einen Magnetfeldgenerator (1) zum Erzeugen eines Magnetfelds (6), wobei das Magnetfeld (6) mit einer Frequenz moduliert ist, und
eine Messvorrichtung (2) mit einem Magnetfeldsensor (3), wobei die Messvorrichtung (2) eingerichtet ist, eine Messfolge von Magnetfeldstärken durch den Magnetfeldsensor (3) zu erfassen und aus der Messfolge die Frequenz des Magnetfelds (6) zu identifizieren, wobei die Messvorrichtung (2) eine Einrichtung zur Bestimmung einer Ortsinformation aufweist,
**dadurch gekennzeichnet, dass**
die Annäherung auf dem Identifizieren der Frequenz des Magnetfelds (6) basiert und in Reaktion darauf bestimmt wird, dass für eine erste Ortsinformation die Frequenz des Magnetfelds (6) identifiziert wird und für eine zweite Ortsinformation die Frequenz des Magnetfelds (6) identifiziert wird, wobei die erste Ortsinformation und die zweite Ortsinformation zueinander beabstandete Orte bezeichnen.

2. System nach einem der vorhergehenden Ansprüche, wobei das Magnetfeld (6) ein Wechselfeld ist, insbesondere durch einen Wechselstrom erzeugt.

3. System nach einem der vorhergehenden Ansprüche, wobei die Messvorrichtung (2) ein Mobiltelefon (2) ist.

4. System nach einem der vorhergehenden Ansprüche, wobei der Magnetfeldgenerator (1) eine Oberleitung (1) zur Versorgung einer elektrischen Bahn (5) mit Bahnstrom umfasst.

5. System nach einem der vorhergehenden Ansprüche, wobei die Messvorrichtung (2) eine Anzeige (9) mit einer grafischen Benutzerschnittstelle (GUI) aufweist, und die Messvorrichtung (2) eingerichtet ist, in Reaktion auf das Identifizieren der Frequenz des Magnetfelds (6) ein grafisches Element in der grafischen Benutzerschnittstelle (GUI) darzustellen.

6. System nach einem der vorhergehenden Ansprüche, wobei das System außerdem einen zweiten Magnetfeldgenerator (1) zum Erzeugen eines zweiten Magnetfelds (6) mit einer zweiten Frequenz umfasst, und wobei
die Messvorrichtung (2) eingerichtet ist, eine erste Frequenz und eine zweite Frequenz aus der Messfolge zu identifizieren.

7. System nach einem der vorhergehenden Ansprüche, wobei der Magnetfeldgenerator (1) eingerichtet ist, das Magnetfeld (6) gleichzeitig mit einer ersten Frequenz und mit einer zweiten Frequenz zu modulieren, und wobei die Messvorrichtung (2) eingerichtet ist, die Annäherung zu bestimmen in Reaktion darauf, dass die erste Frequenz und die zweite Frequenz gleichzeitig identifiziert werden.

8. System nach einem der vorhergehenden Ansprüche, wobei der Magnetfeldgenerator (1) eingerichtet ist, das Magnetfeld (6) mit einer Amplitudenmodulation zu modulieren.

9. Verfahren zur Bestimmung einer Annäherung zwischen
einem Magnetfeldgenerator (1) zum Erzeugen eines Magnetfelds (6), wobei das Magnetfeld (6) mit einer Frequenz moduliert ist, und einer Messvorrichtung (2) mit einem Magnetfeldsensor (3), wobei die Messvorrichtung (2) eine Einrichtung zur Bestimmung einer Ortsinformation aufweist, wobei das Verfahren umfasst:
Erfassen (50) einer Messfolge von Magnetfeldstärken durch den Magnetfeldsensor (3),
Identifizieren (51) der Frequenz des Magnetfelds (6) aus der Messfolge,
**dadurch gekennzeichnet, dass** das Verfahren außerdem umfasst:
Bestimmen (52) der Annäherung basierend auf dem Identifizieren (51) der Frequenz für eine erste Ortsinformation und auf dem Identifizieren (51) der Frequenz für eine zweite Ortsinformation, wobei die erste Ortsinformation und die zweite Ortsinformation zueinander beabstandete Orte bezeichnen.

10. Verfahren nach Anspruch 9, wobei eine Annäherung an eine Oberleitung (1) einer elektrifizierten Bahnstrecke bestimmt wird, wobei das Identifizieren der Frequenz das Identifizieren von 16.7 Hz umfasst.

11. Verfahren nach einem der Ansprüche 9 oder 10, außerdem umfassend:
Ausführen einer Applikation, durch die Messvorrichtung (2), in Reaktion auf das Bestimmen (52) der Annäherung.

12. Verfahren nach einem der Ansprüche 9 bis 11, wobei das Magnetfeld (6) mit einer ersten Frequenz moduliert ist und ein zweiter Magnetfeldgenerator (1) ein zweites Magnetfeld (6) erzeugt, das mit einer zweiten Frequenz moduliert ist, wobei das Verfahren umfasst:
Identifizieren der ersten Frequenz und der zweiten Frequenz durch die Messvorrichtung (2), um eine Annäherung an den Magnetfeldgenerator (1) verschieden von einer Annäherung an den zweiten Magnetfeldgenerator (1) zu bestimmen.

13. Verfahren nach einem der Ansprüche 9 bis 12 unter Verwendung eines Systems nach einem der Ansprüche 1 bis 9.

14. Verwendung eines Mobiltelefons (2) als Messvorrichtung (2) zum Bestimmung einer Annäherung gemäß einem Verfahren nach einem der Ansprüche 9 bis 13.

## Claims

1. A system for determining an approach, comprising:
a magnetic field generator (1) for generating a magnetic field (6), the magnetic field (6) being modulated with a frequency, and
a measuring device (2) having a magnetic field sensor (3), the measuring device (2) being designed to capture a measurement sequence of magnetic field strengths by means of the magnetic field sensor (3) and to identify the frequency of the magnetic field (6) from the measurement sequence, the measuring device (2) having an apparatus for determining location information,
**characterised in that**
the approach is based on the identification of the frequency of the magnetic field (6) and is determined in response to the frequency of the magnetic field (6) being identified for a first piece of location information and the frequency of the magnetic field (6) being identified for a second piece of location information, the first piece of location information and the second piece of location information denoting locations that are at a distance from one another.

2. System according to the preceding claim, wherein the magnetic field (6) is an alternating field, in particular generated by an alternating current.

3. System according to either of the preceding claims, wherein the measuring device (2) is a mobile telephone (2).

4. System according to any of the preceding claims, wherein the magnetic field generator (1) comprises an overhead line (1) for supplying an electric railway (5) with traction current.

5. System according to any of the preceding claims, wherein the measuring device (2) has a display (9) having a graphical user interface (GUI), and the measuring device (2) is designed to display a graphical element in the graphical user interface (GUI) in response to the identification of the frequency of the magnetic field (6).

6. System according to any of the preceding claims, wherein the system further comprises a second magnetic field generator (1) for generating a second magnetic field (6) with a second frequency, and wherein
the measuring device (2) is designed to identify a first frequency and a second frequency from the measurement sequence.

7. System according to any of the preceding claims, wherein the magnetic field generator (1) is designed to modulate the magnetic field (6) simultaneously with a first frequency and with a second frequency, and wherein the measuring device (2) is designed to determine the approach in response to the first frequency and the second frequency being identified simultaneously.

8. System according to any of the preceding claims, wherein the magnetic field generator (1) is designed to modulate the magnetic field (6) using an amplitude modulation.

9. Method for determining an approach between
a magnetic field generator (1) for generating a magnetic field (6), the magnetic field (6) being modulated with a frequency, and a measuring device (2) having a magnetic field sensor (3), the measuring device (2) having an apparatus for determining location information, the method comprising:
capturing (50) a measurement sequence of magnetic field strengths by means of the magnetic field sensor (3) and identifying (51) the frequency of the magnetic field (6) from the measurement sequence, **characterised in that** the method also comprises:
determining (52) the approach on the basis of the identification (51) of the frequency for a first piece of location information and the identification (51) of the frequency for a second piece of location information, the first piece of location information and the second piece of location information denoting locations that are at a distance from one another.

10. Method according to claim 9, wherein an approach to an overhead line (1) of an electrified railway line is determined, wherein identifying the frequency comprises identifying 16.7 Hz.

11. Method according to either claim 9 or claim 10, further comprising;
executing an application, by means of the measuring device (2), in response to the determination (52) of the approach.

12. Method according to either claim 9 or claim 11, wherein the magnetic field (6) is modulated with a first frequency and a second magnetic field generator (1) generates a second magnetic field (6) that is modulated with a second frequency, wherein the method comprises:
identifying the first frequency and the second frequency by means of the measuring device (2) in order to determine an approach to the magnetic field generator (1) differently from an approach to the second magnetic field generator (1).

13. Method according to any of claims 9 to 12 using a system according to any of claims 1 to 9.

14. Use of a mobile phone (2) as a measuring device (2) for determining an approach according to a method according to any of claims 9 to 13.

## Revendications

1. Système pour déterminer un rapprochement, comprenant :
un générateur de champ magnétique (1) pour produire un champ magnétique (6), dans lequel le champ magnétique (6) est modulé avec une fréquence, et
un dispositif de mesure (2) avec un capteur de champ magnétique (3), dans lequel le dispositif de mesure (2) est conçu pour détecter une succession de mesures d'intensités de champ magnétique par le capteur de champ magnétique (3) et pour identifier à partir de la succession de mesures la fréquence du champ magnétique (6), dans lequel le dispositif de mesure (2) présente un appareil pour la détermination d'une information de lieu,
**caractérisé en ce que**
le rapprochement se base sur l'identification de la fréquence du champ magnétique (6) et en réponse à cela il est déterminé que pour une première information de lieu la fréquence du champ magnétique (6) est identifiée et pour une deuxième information de lieu la fréquence du champ magnétique (6) est identifiée, dans lequel la première information de lieu et la deuxième information de lieu désignent des lieux espacés l'un de l'autre.

2. Système selon l'une quelconque des revendications précédentes, dans lequel le champ magnétique (6) est un champ alternatif, en particulier produit par un courant alternatif.

3. Système selon l'une quelconque des revendications précédentes, dans lequel le dispositif de mesure (2) est un téléphone mobile (2).

4. Système selon l'une quelconque des revendications précédentes, dans lequel le générateur de champ magnétique (1) comprend une ligne aérienne (1) pour l'alimentation d'un train électrique (5) avec un courant de traction.

5. Système selon l'une quelconque des revendications précédentes, dans lequel le dispositif de mesure (2) présente un écran (9) avec une interface graphique utilisateur (GUI), et le dispositif de mesure (2) est conçu pour représenter un élément graphique dans l'interface graphique utilisateur (GUI) en réponse à l'identification de la fréquence du champ magnétique (6) .

6. Système selon l'une quelconque des revendications précédentes, dans lequel le système comprend en outre un deuxième générateur de champ magnétique (1) pour produire un deuxième champ magnétique (6) avec une deuxième fréquence, et dans lequel
le dispositif de mesure (2) est conçu pour identifier une première fréquence et une deuxième fréquence à partir de la succession de mesures.

7. Système selon l'une quelconque des revendications précédentes, dans lequel le générateur de champ magnétique (1) est conçu pour moduler le champ magnétique (6) simultanément avec une première fréquence et avec une deuxième fréquence, et dans lequel le dispositif de mesure (2) est conçu pour déterminer le rapprochement en réponse au fait que la première fréquence et la deuxième fréquence sont identifiées simultanément.

8. Système selon l'une quelconque des revendications précédentes, dans lequel le générateur de champ magnétique (1) est conçu pour moduler le champ magnétique (6) avec une modulation d'amplitude.

9. Procédé pour la détermination d'un rapprochement entre
un générateur de champ magnétique (1) pour produire un champ magnétique (6), dans lequel le champ magnétique (6) est modulé avec une fréquence, et un dispositif de mesure (2) avec un capteur de champ magnétique (3), dans lequel le dispositif de mesure (2) présente un appareil pour la détermination d'une information de lieu, dans lequel le procédé comprend :
la détection (50) d'une succession de mesures d'intensités de champ magnétique par le capteur de champ magnétique (3),
l'identification (51) de la fréquence du champ magnétique (6) à partir de la succession de mesures,
**caractérisé en ce que** le procédé comprend en outre :
la détermination (52) du rapprochement sur la base de l'identification (51) de la fréquence pour une première information de lieu et de l'identification (51) de la fréquence pour une deuxième information de lieu, dans lequel la première information de lieu et la deuxième information de lieu désignent des lieux espacés l'un de l'autre.

10. Procédé selon la revendication 9, dans lequel un rapprochement d'une ligne aérienne (1) d'une section de voie électrifiée est déterminé, dans lequel l'identification de la fréquence comprend l'identification de 16.7 Hz.

11. Procédé selon l'une quelconque des revendications 9 ou 10, comprenant en outre :
l'exécution d'une application, par le dispositif de mesure (2), en réponse à la détermination (52) du rapprochement.

12. Procédé selon l'une quelconque des revendications 9 à 11, dans lequel le champ magnétique (6) est modulé avec une première fréquence et un deuxième générateur de champ magnétique (1) produit un deuxième champ magnétique (6), qui est modulé avec une deuxième fréquence, dans lequel le procédé comprend :
l'identification de la première fréquence et de la deuxième fréquence par le dispositif de mesure (2), afin de déterminer un rapprochement du générateur de champ magnétique (1) différent d'un rapprochement du deuxième générateur de champ magnétique (1).

13. Procédé selon l'une quelconque des revendications 9 à 12 au moyen d'un système selon l'une quelconque des revendications 1 à 9.

14. Utilisation d'un téléphone mobile (2) comme dispositif de mesure (2) pour la détermination d'un rapprochement selon un procédé selon l'une quelconque des revendications 9 à 13.
